# EUROPEAN PATENT APPLICATION

(11) **EP 4 683 204 A1**
(43) Date of publication of application: **21.01.2026**
(21) Application number: 24189905.3
(22) Date of filing: 19.07.2024
(51) Int. Cl.: H02P 3/18, B62D 5/04, H02P 29/024, H02P 29/028, H02P 29/032

(54) **DC BUS OVER-VOLTAGE PROTECTION SCHEME FOR FAULT TOLERANT PERMANENT MAGNET MOTOR DRIVES**

(71) Applicant: Goodrich Actuation Systems Limited, Solihull, West Midlands B90 4SS (GB)
(72) Inventor: BENAROUS, Maamar, Solihull, B90 4SS (GB); RASHED MOHAMED ALABASSY, Mohamed Elsayed, Solihull, B90 4SS (GB)
(74) Representative: Dehns

(57) **Abstract**

The technology disclosed herein relates to methods and apparatus for controlling channels of a multi-channel fault tolerant electric motor system experiencing a particular fault, the control maintaining the voltage in the respective DC bus of the channel with the fault below the DC bus overvoltage threshold for that channel, the particular fault being one that as a result of the continued rotation of the rotor of the motor could potentially cause the voltage in the respective DC bus for the channel with the fault to increase above a DC bus overvoltage threshold for that channel.

## Description

### TECHNICAL FIELD

The technology described herein relates to multi-channel motor drive systems for permanent magnet motor systems, and in particular to providing techniques for operating such systems to prevent DC bus overvoltage in the event of a fault within one of the channels of the motor drive system.

### BACKGROUND

In aircraft, there is currently a trend towards so-called More Electric Aircraft (MEA) whereby loads such as flight control surfaces, landing gear, actuators, fans, pumps, etc., which have traditionally been controlled by hydraulic and mechanical systems are now being designed to be controlled electrically by means of an electric motor. For example, Next Generation High Lift Systems (HLS) are envisaged to be highly flexible, distributed and actively controlled using Electro Mechanical Actuators (EMAs) that are driven by an electric motor drive system.

Typical electric motor systems may consist of a simple motor driven by an inverter. To reduce weight and size, permanent magnet motors are often used for aerospace applications since they typically have a higher torque/power density ratio in comparison to other motor drive alternatives such as switched reluctance or induction motors.

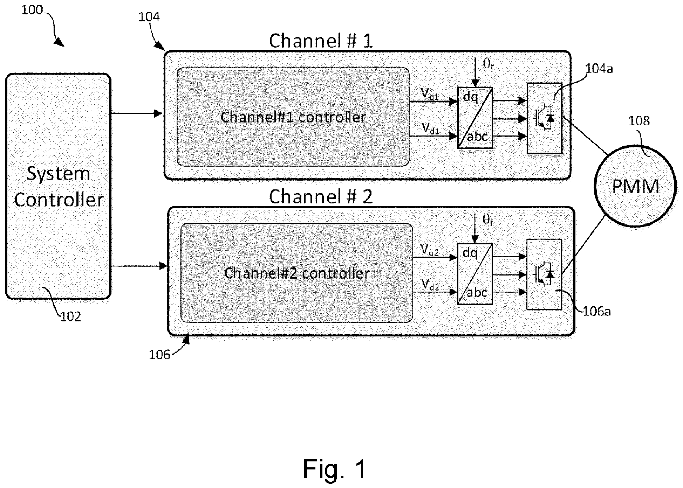

Safety critical aerospace applications require a certain number of redundancies designed into the system architecture and this cannot be achieved using such simplex motor drive architectures. These redundancies have thus been provided by multi-channel motor drive designs as shown, for example, in Figure 1. Figure 1 shows a dual channel (duplex) three phase motor drive system. Thus, in the duplex permanent magnet motor configuration shown in Figure 1, there are two segregated windings (such that each winding is driven by a separate inverter). Such systems may thus be designed to be "fault tolerant" such that if one of the two inverters, or motor windings, of these systems develops a fault, the other inverter can take over and continue to drive rotation of the rotor to control the motor torque generation. Other numbers of multiple channels may of course also be used for increased redundancy.

The Applicants however recognise that there is scope for improvements in the operation of such multi-channel motor drive systems for permanent magnet motor systems.

### SUMMARY

A first embodiment of the technology described herein comprises a method of operating a fault tolerant electric motor system, wherein the motor system comprises a motor that comprises a rotor having a magnet mounted thereto and a stator that comprises one or more motor phase windings connected to a motor drive system for driving rotation of the rotor, wherein the motor drive system comprises a plurality of channels, each channel of the plurality of channels comprising a respective power inverter that can be controlled to provide torque to a respective one of the motor phase windings for driving rotation of the rotor and a respective DC bus for providing power to the respective power inverter, the method comprising:
determining that there is a particular fault in one of the channels of the motor drive system; and
continuing operating the motor system by driving rotation of the rotor using at least one other channel of the motor drive system,
wherein when the particular fault is one that as a result of the continued rotation of the rotor could potentially cause the voltage in the respective DC bus for the channel with the fault to increase above a DC bus overvoltage threshold for that channel, the method further comprises:
   controlling the operation of the channel with the fault to maintain the voltage in its respective DC bus below the DC bus overvoltage threshold for that channel.

It will also be appreciated that the technology described herein also extends to the electric motor system itself.

As such, according to another embodiment of the technology described herein there is provided a fault tolerant electric motor system, the electric motor system comprising a motor that comprises a rotor having a magnet mounted thereto and a stator that comprises one or more motor phase windings connected to a motor drive system for driving rotation of the rotor, wherein the motor drive system comprises a plurality of channels, each channel of the plurality of channels comprising a respective power inverter that can be controlled to provide torque to a respective one of the motor phase windings for driving rotation of the rotor and a respective DC bus for providing power to the respective power inverter, a control circuit of the motor drive system is configured to:
determine that there is a particular fault in one of the channels of the motor drive system; and
continue to operate the motor system by driving rotation of the rotor using at least one other channel of the motor drive system,
wherein when the particular fault is one that as a result of the continued rotation of the rotor could potentially cause the voltage in the respective DC bus for the channel with the fault to increase above a DC bus overvoltage threshold for that channel, control the operation of the channel with the fault to maintain the voltage in its respective DC bus below the DC bus overvoltage threshold for that channel.

The technology described herein relates to the operation of multi-channel motor drive systems for permanent magnet motor systems, and in particular to the operation of such systems in the event of one of the channels of the motor drive system developing a fault. In particular, the technology described herein relates to so-called "fault tolerant" motor systems that in the event of a fault (or faults) affecting one of the channels are operable to continue generating useful output (torque) (e.g.) using the remaining "healthy" channel(s).

The Applicants recognise that, because the magnet in a permanent magnet motor system cannot simply be switched off, in such "fault tolerant" motor systems, in the event of particular types of fault affecting one of the channels, the continued rotation of the rotor due to the ongoing operation of the motor using the remaining "healthy" channel(s) may continue to induce significant back emf in the channel with the fault, at least at higher motor speeds. The Applicants further recognise that in some instances this induced back emf can cause permanent damage to the electric motor system.

(It will be appreciated that this is a particular problem for such multi-channel motor drive systems as for simplex motors the motor may be simply shut down in the event of any fault.)

In some more traditional motor systems, to (try to) mitigate any risk of permanent damage in the event of a fault, the motor system may therefore be relatively 'oversized', e.g. such that the power components within each channel of the motor drive system are rated to cope with relatively higher voltages than would be expected to occur under typical fault conditions. In that case, in the event of a fault in one of the channels, no particular action may need to be performed in this respect. Increasingly, however, in order to reduce size/weight, modern electric motor systems are designed such that at certain motor speeds the motor back emf will greatly exceed the voltage rating of the power components within the channels of the motor drive system. This is especially the case, for example, for aircraft applications, where there is a continued push towards size/weight reduction.

Thus, in embodiments, the electric motor system of the technology described herein is designed such that, in normal/healthy operation, the motor back emf at certain motor speeds (e.g. motor speeds that are above a certain threshold motor speed) exceeds the voltage rating of at least some of the power components in the respective channels of the motor drive system.

Accordingly, in normal/healthy operation, when the motor is operating at higher motor speeds, the motor back emf may increase to such a level that it starts to limit the motor phase current within the respective channel (or channels) of the motor drive system that are driving rotation of the rotor (i.e. due to the motor back emf effectively limiting the available voltage difference that can be utilised to push the motor current required to produce the motor torque demand at such high speeds). To address this, appropriate control (e.g. (deep) field weakening) may therefore be applied to the (healthy) channel(s) that are driving the rotor to thus allow the motor to operate at increased speeds without the need to increase the DC bus voltage. The field weakening control in normal/heathy operation may be performed in any suitable and desired manner, e.g. in the normal manner for such field weakening control techniques.

In the event of particular types of fault affecting one of the channels of the electric motor system, there may however be a certain loss of control in that channel, as the motor operation will instead (primarily) be controlled using the remaining healthy channels. In the case where the motor back emf is designed to exceed the voltage rating of the power components at a given working speed, the back emf induced in the channel with the fault due to the continued rotation of the rotor can therefore (if left unregulated) create high regenerative motor power returning to the DC bus and hence may create dangerously high DC bus voltages in the channel with the fault.

Thus, in general, there are certain, particular failure conditions that may, if not appropriately managed, result in the voltage in the faulty channel due to the induced back emf exceeding the maximum rated voltage level of the power components within that channel, such as the switches, diodes, capacitors, etc., thus potentially causing permanent damage to the motor system.

For instance, in some more traditional motor systems, once a fault has occurred within a channel, the operation of the channel with the fault may not be specifically monitored or controlled. For example, if the motor is oversized, this may not be perceived as a significant risk. However, the Applicants recognise that in certain circumstances there is still risk of permanent damage, especially for reduced size/weight motor systems (which as mentioned above are typically designed for high back emf and low current).

The technology described herein thus provides techniques for mitigating these issues by identifying occurrences of such particular faults wherein the induced back emf may cause the voltage in the DC bus for the channel with the fault to exceed a maximum rated voltage level, and when there is a risk that the voltage in the DC bus could potentially exceed the maximum rated voltage level (e.g. when the motor is operating above a certain motor speed), performing appropriate control to maintain the DC bus voltage in the channel with the fault at an acceptable level, thus reducing the risk of permanent damage to the motor system.

Examples of particular faults that may as a result of the continued rotation of the rotor could potentially regenerate power to the DC bus and may cause the voltage in the respective DC bus for the channel with the fault to increase above a DC bus overvoltage threshold for that channel, may include any of: (i) a loss of power to the DC bus for that channel; (ii) an open circuit fault affecting a (single) switch within the inverter for that channel (a one-switch open circuit fault); or (iii) an open circuit of a motor phase winding being driven by that channel. The technology described herein thus particularly provides techniques for managing any one or more of these particular faults, as will be described further below.

In this respect, various (different) control techniques may be applied depending on the particular type of fault that is encountered, e.g. as will be explained further below. Thus, the technology described herein may comprise (a controller for the electric motor system) determining which particular type of fault is occurring, and then based on that determination selecting an appropriate control technique (from a (finite) set of control techniques that are available to the electric motor system (controller)) to be applied to maintain the voltage in the DC bus below the DC bus overvoltage threshold for that channel.

It will be appreciated that there may also be other types of faults that are encountered and the technology described herein may or may not be applied in those events. For example, there may be some types of faults that do not risk causing DC bus overvoltage, and so the control of the technology described herein may not be applied. Various arrangements would be possible in this regard.

It may also be the case that at certain operating conditions, e.g. at lower motor speeds, the induced back emf is relatively lower, such that there is - under the current operating conditions - no potential risk of DC bus overvoltage, as only when the motor speed increases would the motor back emf become large enough to risk DC bus overvoltage, e.g. due to uncontrolled regenerative power flow from the motor to the DC bus.

Thus, in embodiments, the control that is performed also takes into account the current operating conditions of the motor so that corrective action to maintain the voltage in the DC bus below the DC bus overvoltage threshold for that channel is (only) taken when there is an imminent risk of DC bus overvoltage (due to uncontrolled regeneration of power from the motor to the DC bus (which may also cause high motor drag torque)) (whereas when there is no imminent risk of DC bus overvoltage, no (or different) corrective action is taken).

For instance, the electric motor system (controller) may comprise fault identifying circuitry that is operable and configured to monitor the operating conditions (e.g. rotational speed of the motor (motor speed), and/or induced back emf), and to perform control actions to maintain the DC bus voltage below the DC bus overvoltage threshold (only) when certain conditions regarding the operating conditions are satisfied (e.g. when the rotational speed of the motor exceeds a certain rotational speed value and/or when the induced back emf exceeds a certain value).

Thus, there may be a threshold motor speed or threshold back emf at which the particular control operations according to the technology described herein are applied. For instance, the certain conditions regarding the operating conditions comprise when the rotational speed of the motor exceeds a certain rotational speed value (a first threshold value) where a back emf induced in the motor windings exceeds the voltage at the DC bus power under healthy operation (i.e. a supply voltage of a power supply providing power to the DC bus) and/or when the induced back emf exceeds the voltage at the DC bus under healthy operation (i.e. a supply voltage of a power supply providing power to the DC bus). Under these conditions the back emf may no longer be regulated (e.g. by the DC bus power supply) and so appropriate control may need to be performed to maintain the DC bus voltage below the DC bus overvoltage threshold. In this respect, it will be appreciated that different thresholds may be used for different fault types and/or different control operations.

The electric motor system (controller) may also comprise (further) fault identifying circuitry that can be used to monitor the state of health of the inverter switches and motor phase windings (i.e. whether switches/motor phase windings of the inverters have experienced (open or short) circuit faults), such fault identifying circuitry then therefore being configured to detect when particular faults have occurred in the electric motor system. It will be appreciated that this (further) fault identifying circuitry may share components/circuitry with the fault identifying circuitry that is operable and configured to monitor the operating conditions, but could also be provided separately, and various arrangements would be possible in this regard.

However, as described above, the electric motor system may continue to operate normally when a fault is detected as there is no imminent risk of DC bus overvoltage. Thus, even if the (further) fault identifying circuitry determines there is a fault in the inverter switches or motor phase windings of a channel of an electric motor system, at least under certain operating conditions of the motor system, the motor system will continue to operate normally (i.e. without performing specific control to maintain the DC bus voltage below the DC bus overvoltage threshold).

Thus, in embodiments, during the continued operating of the motor system after a fault is identified, the voltage in the respective DC bus of the channel with the fault and/or the motor speed is monitored, and the controlling the operation of the channel with the fault to maintain the voltage in its respective DC bus below the DC bus overvoltage threshold for that channel is performed based on the monitoring of the voltage in the respective DC bus of the channel with the fault and/or the motor speed (e.g. based on the certain first threshold value described above).

As mentioned above, one particular type of fault that could potentially cause the voltage in the respective DC bus for the channel with the fault to increase above a DC bus overvoltage threshold for that channel is a loss of power to the respective DC bus for that channel. In an embodiment, the loss of power to the respective DC bus is a fault in the power supply to the respective DC bus.

Thus, in embodiments, each channel of the plurality of channels comprises a respective power inverter that can be controlled to provide torque to a respective one of the motor phase windings for driving rotation of the rotor and a respective DC bus for providing power to the respective power inverter, and the DC bus is connected to a respective power supply (which power supply is operable to regulate the voltage supplied to the DC bus).

Determining that there is a particular fault in one of the channels of the motor drive system may thus comprise determining that there is a loss of power to the respective DC bus for that channel.

In that event, i.e. when the particular fault in the one of the channels of the plurality of channels is a loss of power to the respective DC bus for that channel, controlling the operation of the channel with the fault to maintain the voltage in the DC bus for the channel with the fault below the DC bus overvoltage threshold for that channel may (and in some embodiments does) comprise applying field weakening control to the channel with the fault.

Alternatively, in some (other) embodiments, controlling the operation of the channel with the fault to maintain the voltage in the DC bus for the channel with the fault below the DC bus overvoltage threshold for that channel in the event a loss of a power to the respective DC bus for that channel may comprise applying a short circuit to (all) the motor phases of the channel with the fault.

Various other examples would be possible.

Another example of a particular type of fault that could potentially cause the voltage in the respective DC bus for the channel with the fault to increase above a DC bus overvoltage threshold for that channel is an open circuit fault. Such an open circuit fault may for example affect one of the motor phases in the channel with the fault such that the affected motor phase is no longer controllable, but wherein the other motor phases are still controllable.

For instance, an open circuit fault could affect a (single) open circuit fault in a switching element of the respective power inverter, such an open circuit fault thus causing the switching element to not conduct electrical current across its terminals. As another example, an open circuit fault could be a (single) open circuit fault in a motor phase winding of the channel with the fault, such an open circuit fault causing an open circuit in that motor phase. In both cases, there is a risk that the back emf in the faulty channel may cause the voltage in the respective DC bus for the channel with the fault to increase above a DC bus overvoltage threshold for that channel.

When the particular fault in the one of the channels of the plurality of channels is an open circuit fault affecting one of the motor phases in the channel (whether that be a fault affecting a switching element of the respective power inverter, or a fault affecting the motor phase winding), so long as a respective power supply for the DC bus of the channel with the fault is connected and functioning, the voltage in the respective DC bus can be (and in embodiments is) maintained below the DC bus overvoltage threshold for that channel by: configuring the respective power inverter of the channel with the fault to be in a regenerative configuration such that the power inverter generates power to the DC bus, the respective power supply for the DC bus maintaining the voltage in the DC bus for the channel with the fault below the DC bus overvoltage threshold for that channel.

In this respect, the Applicant has recognised that so long as the respective power supply to the DC bus is still connected to the DC bus and functioning, the voltage of the DC bus can be regulated below the DC bus overvoltage threshold by the power supply.

For instance, in embodiments where the back emf is regenerating power to the DC bus, if the back emf is greater than the DC bus voltage, regenerative power can be supplied to the DC bus from the continued rotation of the motor. However, in this respect, in these embodiments, given the power supply to the DC bus is still connected and functioning, the power supply can vary its power being supplied to the DC bus to maintain the voltage at the DC bus below the DC bus overvoltage threshold, as needed.

In other embodiments where the motor back emf is lower than the DC bus voltage, no action may need to be taken as the (DC) power supply regulates the voltage at the DC bus to be maintained below the DC bus overvoltage threshold.

In embodiments where the inverter comprises switching elements in parallel with free-wheeling diodes, configuring the respective power inverter of the channel with the fault to be in a regenerative configuration may comprise causing (all of) the switching elements of the inverter to be in an open circuit (and in some embodiments, all of the switching elements not associated with an open circuit fault).

In embodiments wherein the particular fault in the one of the channels of the plurality of channels is an open circuit fault affecting one of the motor phases in the channel with the fault such that the affected motor phase is no longer controllable, but wherein the other motor phases are still controllable, configuring the respective power inverter of the channel with the fault to be in a regenerative configuration comprises causing the switching elements corresponding to the controllable motor phases to be in an open circuit.

It will be appreciated from the above that so long as the respective power supply to the DC bus is still connected to the DC bus and functioning, the power supply can regulate the voltage in the DC bus below the DC bus overvoltage threshold, and so placing the power inverter into a regenerative configuration as described above may work well. However, if there is also a loss of power to the respective DC bus for that channel, such that the respective power supply for the DC bus of the channel with the fault is no longer connected and functioning, the power supply may then no longer be able to regulate the voltage in the DC bus and the unregulated back emf itself could exceed the DC bus overvoltage threshold.

Accordingly, in embodiments where (it is determined that) there is both an open circuit fault in the channel with the fault and where there is a loss of power to the respective DC bus for that channel, such that the respective power supply for the DC bus of the channel with the fault is no longer connected and functioning, other control schemes are performed to maintain the DC bus below the DC bus overvoltage threshold.

For example, and in an embodiment, in that case controlling the operation of the channel with the fault to maintain the voltage in its respective DC bus below the DC bus overvoltage threshold for that channel comprises applying a short circuit to (all of the) (controllable) motor phases (windings) of the channel with the fault.

Other arrangements would however be possible.

More generally, as an alternative to placing the inverter in a regenerative configuration as described above, and relying on the power supply to regulate the voltage in the DC bus, controlling the operation of the channel with the fault to maintain the voltage in its respective DC bus below the DC bus overvoltage threshold for that channel may comprise applying a short circuit to (all of the) (controllable) motor phases (windings) of the channel with the fault (i.e. even if there is no loss of power to the DC bus).

As another example, in the event of an open circuit fault affecting one of the channels, field weakening control may be applied to maintain the voltage in its respective DC bus below the DC bus overvoltage threshold for that channel.

Thus, in embodiments, each channel provides a plurality of motor phases, and where the particular fault in the one of the channels of the plurality of channels is an open circuit fault affecting one of the motor phases in the channel with the fault such that the affected motor phase is no longer controllable, but wherein the other motor phases are still controllable, controlling the operation of the channel with the fault to maintain the voltage in the DC bus for the channel with the fault below the DC bus overvoltage threshold for that channel comprises applying field weakening control to the channel with the fault, the field weakening control being applied using the other, controllable motor phases of that channel.

The field weakening control may be applied whilst the respective power supply from the DC bus of the channel of the fault is connected and functioning, in which case the faulty channel may be used to provide assistive torque. In some embodiments, however, the control further comprises disconnecting a respective power supply from the DC bus of the channel with the fault; and applying field weakening control using the controllable motor phases of that channel. In that respect, the power supply could be disconnected prior to applying any field weakening control or could be disconnected after the field weakening control is started.

If therefore, there is both an open circuit fault and a loss of power to the respective DC bus for that channel, in embodiments, field weakening control can still be applied to maintain the DC bus voltage below the DC bus overvoltage threshold by disconnecting the respective power supply from the DC bus of the channel with the fault. This can then help reduce drag torque and torque ripples.

In some embodiments, in the case where the open circuit fault is an open circuit fault in a switch (switching element) of the respective power inverter, field weakening control may be performed when the motor speed exceeds a certain, (pre-determined) threshold speed (which may, e.g., and in embodiments is, a (first) threshold motor speed at which the motor back emf would be higher than the DC bus voltage in healthy operation, and at which point the particular control according to the technology described herein may therefore start being performed, as discussed above).

Field weakening control could be applied at all speeds above this certain (first) threshold speed. In this respect, however, the Applicants have recognised that it may be desirable to (only) apply field weakening control up to a certain (second) ("field-weakening") threshold motor speed, such that field weakening control is only performed over a restricted range of motor speeds. For example, at motor speeds above the certain (second) ("field-weakening") threshold motor speed, the field weakening control may be stopped, and instead a (three-phase) short circuit may be applied to (all) the motor phase (windings) (instead of field-weakening control). At these higher motor speeds, this can reduce the drag torques and torque ripples compared to, e.g., continuing applying field weakening control.

The second, higher, ("field-weakening") threshold speed can be predetermined and/or based on a pre-characterisation of the motor.

Accordingly, in embodiments, when the open circuit fault affecting one of the motor phases in the channel with the fault is an open circuit fault in one switch of the respective inverter of the channel with the fault:
the field weakening control using the controllable motor phases of that channel is applied when the motor speed is greater than or equal to a certain (first) threshold speed.

In embodiments, the field weakening control is (only) applied when the motor speed is within a certain range of motor speeds, i.e. above the certain (first) threshold speed mentioned above but below a certain (second) threshold speed. In embodiments, when the motor speed is above the (second) higher threshold speed, other control is performed to maintain the voltage in the DC bus for the channel with the fault below the DC bus overvoltage threshold.

In embodiments, the other control that is performed at motor speeds above the (second) higher threshold speed may be any one of the other control schemes of the technology described herein. In one embodiment, the other control comprises applying a short circuit to (all) the motor phases (motor phase windings) of the channel with the fault. Thus, the control that is performed to maintain the voltage in the DC bus below the DC bus overvoltage threshold may comprise initially (at motor speeds above a first threshold speed) applying field weakening control and then (at motor speeds above a second threshold speed) applying a short circuit to (all) the motor phase (windings) of the channel with the fault.

This can allow assistive torque to be provided by the channel with the fault during a reduced range of motor speeds (or provide reduced torque ripples and drag torques), where it is appropriate to do so, but at higher motor speeds a short circuit is applied to reduce drag torque and torque ripples (compared to applying a short circuit to the motor phase terminals).

In other embodiments, the voltage in the DC bus for the channel with the fault can be maintained below the DC bus overvoltage threshold using other control by configuring the respective power inverter of the channel with the fault to be in a regenerative configuration such that the power inverter generates power to the DC bus, so long as a respective power supply for the DC bus of the channel with the fault is connected and functioning, as described above.

In contrast, where the open circuit fault is in a motor phase winding of the channel with the fault, field weakening may be applied at any motor speed. In an embodiment, field weakening control is applied for open circuit motor phase winding faults when the motor speed exceeds a certain value (this certain value being one where continued rotation of the motor with the open circuit motor phase winding fault would cause the voltage as the DC bus to exceed the DC bus overvoltage threshold, e.g. the first threshold discussed above).

As mentioned above, it will be appreciated that in embodiments, the operation of the channel with the fault can be controlled to maintain the voltage in its respective DC bus below the DC bus overvoltage threshold for that channel according to multiple different control schemes, and a control scheme for controlling the operation of the channel with the fault can be selected based on the particular type of fault that is determined.

The control circuit (circuitry) for the electric motor system may be implemented in any suitable manner, as desired. For example, this may be implemented either in hardware or software (including embedded software), as desired, using any suitable processor or processors, controller or controllers, functional units, circuitry, processing logic, microprocessor arrangements, etc., that are operable to perform the various functions, etc., such as appropriately dedicated hardware elements (processing circuitry) and/or programmable hardware elements (processing circuitry) that can be programmed to operate in the desired manner.

The methods in accordance with the technology described herein may thus be implemented at least partially using software e.g. embedded software. The controller may thus comprise a suitable microprocessor or microcontroller that is configured to execute software to perform the various operations described herein.

It will thus be seen that when viewed from further embodiments the technology described herein provides software specifically adapted to carry out the methods herein described when installed on a suitable data processor, a computer program element comprising software code portions for performing the methods herein described when the program element is run on a data processor, and a computer program comprising code adapted to perform all the steps of a method or of the methods herein described when the program is run on a data processing system.

Other arrangements would however be possible. For instance, the methods may also be implemented at least partially using appropriately dedicated hardware elements (processing circuitry) and/or programmable hardware elements (processing circuitry, e.g. such as a programmable FPGA (Field Programmable Gate Array)) that form part of the motor controller and can be programmed to operate in the desired manner. It would also be possible to implement the methods described above using analogue logic, for example.

Subject to the requirements of the technology described herein, the motor system may otherwise comprise any suitable and desired features that a permanent magnet motor system may comprise.

In that respect, it will be appreciated that whilst reference is made herein to a permanent magnet motor system having two channels, it will be appreciated that there may in general be any suitable number of channels provided, and any number of motor phase windings (such as two, three, or more) and that these further channels can also be operated in the same manner described above.

Various other arrangements would of course be possible.

### BRIEF DESCRIPTION OF DRAWINGS

Various embodiments will now be described, by way of example only, with reference to the drawings.
Figure 1 is a schematic diagram of an example of a duplex permanent magnet motor drive system.
Figure 2 is a schematic diagram showing an example of a two-level three-phase inverter topology.
Figure 3 is a show simulated results for control schemes applied to a channel under a loss of power to its DC bus
Figure 4 is a schematic diagram of showing an example of a two-level three-phase inverter topology with an open circuit fault in a switch.
Figure 5 showing an example of a two-level three-phase inverter topology with an open circuit fault in a motor phase winding.
Figure 6 shows simulated results for control schemes applied to a channel under one motor phase open circuit fault
Figure 7 shows simulated results for control schemes applied to a channel under one motor phase open circuit fault
Figure 8 is a schematic diagram showing a duplex permanent magnet motor drive system according to an embodiment.
Figure 9 is a flowchart for controlling a motor channel according to an embodiment.

Like reference numerals are used for like components where appropriate in the Figures.

### DETAILED DESCRIPTION

As briefly described above, Figure 1 shows an example motor drive for a permanent magnetic motor 108. In the system 100 of Figure 1, the duplex permanent magnet motor comprises two segregated windings, with each winding being driven by a respective channel. The system controller 102 is therefore operably connected to the permanent magnetic motor 108 via two channels 104, 106, each channel comprising a respective inverter circuit 104a, 106a that provides one or more phases of AC output to its respective motor winding. The use of two separate inverters 104a, 106a each corresponding to one of the channels 104, 106 provides redundancy in the system, as the second inverter (e.g. 106a) is able to take over and control the motor torque in the event that the first inverter (e.g. 104a) develops a fault. This duplex arrangement is therefore particularly suitable for safety critical applications such as for driving electric motors within aircrafts, such as for High Lift Systems. However, different numbers of channels and inverters may of course be used, as desired.

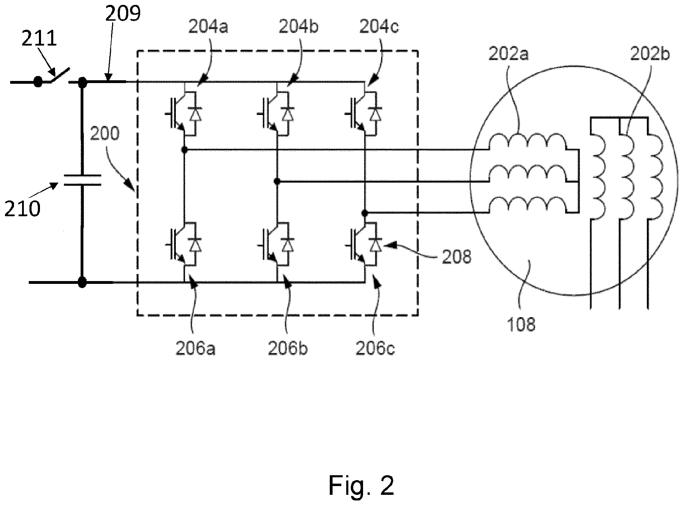

Figure 2 shows an example of a two-level three-phase inverter circuit 200 that could be used for the respective channels of the system 100 of Figure 1. Thus, as shown in Figure 2, the inverter output is operably connected to the windings 202a of the first channel 104 which are wound about a permanent magnetic motor 108. Although not shown in Figure 2, it will be understood that a second equivalent inverter system will be provided for the windings 202b of the second channel 106.

The exemplary inverter circuit 200 in Figure 2 comprises six switches, including three top switches 204a,b,c and three bottom switches 206a,b,c. Each switch 204/206 is connected in parallel with a respective freewheeling diode 208. Each series connection of a top switch and a bottom switch forms a switch arm of the inverter circuit 200. Under normal operating conditions, the switches are operable to control the inverter output, e.g. in the normal manner for a switching inverter.

It will be understood that the number of switch arms in the inverter circuit 200 correlates with the number of desired output phases (i.e. three, in this example), and that the inverter may comprise a different number of switch arms if desired, including but not limited to 1, 2, 3, 4 or more switch arms corresponding to respective single-, two-, three-, four-, etc. phase output topologies.

Other inverter topologies can also be used as appropriate.

As shown in Figure 2, the inverter circuit 200 is electrically connected to a DC bus 209 that provides electrical power to inverter circuit 200. The DC bus has capacitor 210 (DC link capacitor 210) connected across its terminals. Thus, although not shown in Figure 2, it will be appreciated that there will also be a separate power generator as well as appropriate power conditioning circuits (e.g. rectifiers, transformers, DC-DC voltage converters, or otherwise, as appropriate) that form part of the aircraft power supply system and that provide power to the DC bus 209, as well as other electrical components within the aircraft.

It will further be appreciated that the inverter circuit 200 will also be associated with a system control board comprising a switch driver controller (not illustrated in Figure 2) that provides (lower power) switching signals to control the switching of the switches 204a,b,c-206a,b,c of the inverter circuit 200 to thereby convert the DC power supplied to the inverter circuit 200 via the DC bus 209 into an appropriate AC power for driving the motor phase windings of the motor. The system control board could also be supplied by the DC bus 209, but more typically it is connected to its own, lower voltage, power supply. For example, in aircraft applications, system control board may be connected to the aircraft 28VDC bus. Various arrangements would be possible in this regard.

The various components of the inverter circuit 200, such as the switches 204a,b,c, 206a,b,c and freewheeling diodes 208, and the DC link capacitor 210 connected across the terminals of the DC bus 209 are each typically associated with a maximum rated voltage level, wherein if the voltage across the terminals of such components exceeds their respective maximum rated voltages, permanent damage may then be caused.

An electric motor system should therefore generally be designed such that, at least under normal operating conditions, the voltage across the various components of the inverter circuit 200 and the DC link capacitor 210 do not exceed their maximum rated voltage levels. Increasingly, however, to facilitate size/weight reduction, modern electric motor systems are being designed to push the back emf constant higher such that the back emf induced in the inverter circuit 200 by the motor phase windings may at certain (higher) motor speeds exceed the maximum rated voltage level of the DC link capacitor 210 and system components. In that case, in normal/healthy operation, field-weakening control may therefore be applied at higher motor speeds in order to reduce the motor back emf to an acceptable level for the voltage in the DC bus 209 to push the required motor current to produce the motor demand torque.

The present Applicants recognise, however, that under certain failure conditions, the back emf induced in the inverter circuit 200 of the channel with the fault as a result of the continued rotation of the rotor may cause uncontrolled regenerative power to the DC bus 209 which may cause the voltage of the DC link capacitor 210 to increase significantly, as the normal control of that channel has been lost. Therefore, if this is not managed, e.g. by limiting the motor performance (or oversizing the motor), permanent damage may be caused to the DC link capacitor 210 (for example) and also potentially to other components of inverter 200 (e.g. the switches and free-wheeling diodes) in the channel with the fault.

For instance, in the case of "fault tolerant" motors, as discussed above, if there is a fault in a first channel, e.g. channel 104, the rotor of the motor will continue to rotate under the control of a second channel, e.g. channel 106, or otherwise (e.g. due to the rotational system inertia). As the permanent magnets of the rotor cannot be deactivated, a back emf will continue to be induced in the motor windings of the first, faulty, channel. This induced back emf can cause the voltage at DC bus 209 to increase, and at least under certain operational conditions, e.g. at higher rotational speeds of the rotor, the voltage in the DC bus 209 could potentially increase above the maximum rated voltage level for the DC bus 209, causing damage to the DC link capacitor 210 and/or to other inverter 200 components.

The present Applicants thus recognise that when such faults are occurring, appropriate action can (and should) be taken to prevent the voltage at the DC bus 209 from exceeding its maximum rated voltage, so that the voltage across the terminals of the DC link capacitor, and other components of the inverter 200, do not exceed their maximum rated voltage, preventing damage to the DC link capacitor 210 and the other inverter 200 components. According to the technology described herein, therefore, the motor drive system channels are monitored during operation to identify occurrences of respective faults within the channels, and in particular, to identify particular faults that could potentially, i.e. if not controlled, cause the DC bus voltage to exceed a certain "DC bus overvoltage threshold" for that channel. Further, when such particular faults are identified, appropriate control is then performed to keep the DC bus voltage below the respective DC bus overvoltage threshold and to reduce motor drag torque for that channel.

In this respect, it will be appreciated that each respective channel may have its own respective, potentially different DC bus overvoltage threshold based on which such control is performed (although more typically the channels will have the same DC bus overvoltage thresholds). It will also be appreciated that the DC bus overvoltage threshold based on which such control is performed may or may not correspond to the maximum voltage rating of any of the components within the channel. For example, the DC bus overvoltage threshold for a channel could be set as the lowest maximum voltage rating of any of the components within that channel, such that the control is performed to keep the DC bus voltage below the maximum voltage rating of the component having the lowest maximum voltage rating. However, in general, the DC bus overvoltage threshold for a channel may be set as desired, e.g. such that it is lower than the maximum voltage rating of any of the components within the channel. Various arrangements would be possible in this regard for selecting a suitable DC bus overvoltage threshold.

As will be explained further below, when such particular faults are identified, particular control operations are then applied to keep the DC bus voltage below the DC bus overvoltage threshold. In this respect, the particular control operations could be applied to the faulty motor channel as soon as the particular fault is identified. However, the present Applicants recognise that this may not be necessary, as depending on the operating parameters of the motor at the time the fault occurs, there may or may not be actual risk of damage.

Thus, in embodiments, the DC bus voltage is monitored as part of the control, and (only) when the DC bus voltage approaches or exceeds the DC bus overvoltage threshold is action taken to reduce the DC bus voltage.

This could also be done based on monitoring the motor speed. For instance, in general the back emf is proportional to motor speed. Thus, when the motor is operating at a motor speed below a threshold motor speed, the back emf induced within the motor phase windings may be sufficiently low that even though a fault is occurring in one of the channels, there is little to no risk of damage to the DC link capacitor (as the DC bus voltage will not exceed the DC bus overvoltage threshold). Thus, it may not be necessary to perform any particular action at this point, and in embodiments, no action is performed until the motor speed exceeds a certain threshold motor speed, i.e. such that the back emf generated in the inverter circuit 200 may cause the voltage in the DC bus 209 to exceed the DC bus overvoltage threshold.

That is, in embodiments, the particular control that is performed according to the technology described herein to maintain the voltage below the DC bus overvoltage threshold also takes into account the voltage in the DC bus 209 of the channel with the fault and/or the motor speed so that corrective action is only performed when it is necessary to do so, rather than whenever a fault is identified.

Various arrangements would be possible in this regard.

There may be various different types of fault that may cause this problem, and so different types of control or corrective action may be appropriate for the different types of faults. Therefore, depending on the type of fault, different actions are taken to reduce the effects of the back emf and maintain the DC bus voltage below the DC bus overvoltage threshold. Various examples will be described in this regard below.

### Example 1 - Loss of DC power supply

Considering Figure 2, if DC bus 209 were to lose its supply of power (e.g. there is a fault with the power supply powering the DC bus 209 or switch 211 (Figure 2) is open circuit), the voltage on the DC bus 209 may be the backpropagated back emf. In that case, at higher motor speeds, when the rotational speed of the rotor exceeds a certain value, the voltage on the DC bus 209 may, if not controlled, exceed the DC bus overvoltage threshold.

In a first example, this is controlled by applying a three-phase short to the motor phase windings 202a. This can then maintain the voltage on the DC bus 209 below the DC bus overvoltage threshold. For instance, applying a three-phase short to the motor phase windings 202a may comprise either short circuiting the upper branch switches 204a, 204b, 204c or short circuiting the bottom branch switches 206a, 206b, 206c. When the short circuits are applied, the voltage across the DC link capacitor 210 would decrease to zero, meaning the voltage across the DC bus would not reach the DC bus overvoltage threshold, protecting the DC link capacitor from damage.

The short circuit could be applied to the motor phase windings 202a directly in response to detecting a loss of DC power supply, i.e. immediately after this fault is detected. As alluded to above, however, the voltage on the DC bus 209 may never exceed the DC bus overvoltage threshold under certain operating conditions, e.g. at lower motor speeds such that in that case there may be no risk of damage (and e.g. therefore it will be sufficient to switch off inverter 200, or otherwise). Hence, such short circuits are in embodiments (only) applied when the back emf produced at the windings of the faulty channel could potentially cause the voltage at the DC bus to exceed the DC bus overvoltage threshold, e.g. when the rotational speed of the rotor exceeds a certain (predetermined, preselected) value (e.g. such a speed being one where the voltage level of the back emf exceeds the voltage of the DC bus 209 in healthy operation).

Short circuiting the motor phases in this way can thus help maintain the voltage on the DC bus 209 below the DC bus overvoltage threshold. On the other hand, by short circuiting the motor phases of the faulty channel in this way, there may be an increase in the drag torque produced by the motor phases of the faulty channel, meaning that the other (healthy) channels have to produce more torque to maintain a desired motor speed, i.e. as they will also have to overcome the increased drag torque. This then means that the channels may have to be oversized to be able to overcome such drag torques.

Therefore, in another example, rather than applying a three-phase short circuit to the motor phase windings 202a, as described above, field weakening control is applied to the motor phases of the faulty channel to reduce the back emf induced in the motor phases of the motor phases of the faulty channel, thereby controlling and maintaining the voltage at the DC bus below the DC bus overvoltage threshold.

Again, this field weakening control is in embodiments done (only) when the back emf produced at the windings of the faulty channel could potentially cause the voltage at the DC bus to exceed the DC bus overvoltage threshold, e.g. when the rotational speed of the rotor exceeds a certain value. When the motor's rotational speed and the induced motor back emf in the channel with the fault are low (e.g. when the rotational speed of the motor is below the certain value), it would be sufficient to switch off inverter 200 (i.e. open circuit all switches of inverter 200), and in this case there would be no motor current or drag torque.

This field weakening control can be performed in any suitable and desired manner. For instance, the switching of the switches 204 206 of the inverter circuit 200 associated with the faulty channel can be controlled (by the switch driver controller, which in this example is still receiving power from its respective power supply, and thus still operable to control the switching of the switches 204 206) to apply field weakening to the motor, reducing the back emf induced in the motor phase windings of the faulty channel (thereby controlling and maintaining the DC bus voltage below the DC bus overvoltage threshold).

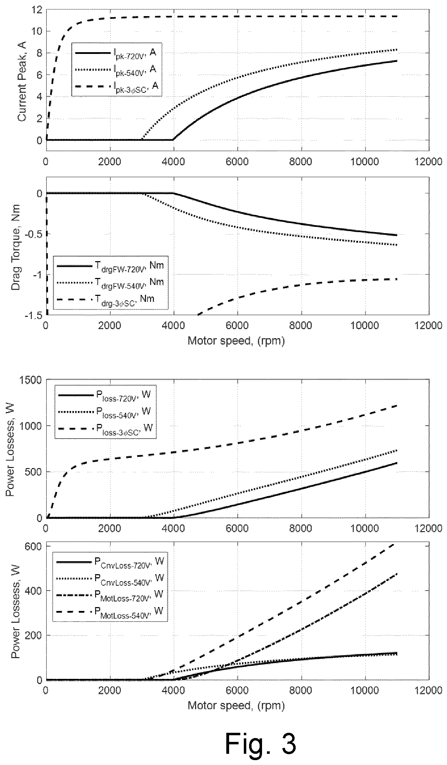

Figure 3 shows simulation results for a motor drive system similar to that of Figure 1 where a channel of the motor drive system experiences loss of power to its DC bus, and a control scheme is applied to maintain the voltage at the DC bus below the DC bus overvoltage threshold.

In particular, Figure 3 shows peak currents, drag torques, and power losses, in the faulty channel when applying field weakening control (controlling the DC bus voltage to either 540VDC or 720VDC), and when applying a short circuit to the motor phases of the faulty channel.

As can be seen in Figure 3, the peak currents, drag torques, and power losses when applying field weakening control (to the motor phases of the faulty channel) to maintain the DC bus voltage below either 540VDC or 720VDC are lower than those when applying a short-circuit to the motor phases of the faulty channel at high speeds.

Other faults within a motor channel of the motor system can also cause the DC bus voltage to exceed the DC bus overvoltage threshold, potentially causing damage to the DC link capacitor.

### Example 2 - (One) Switch Open circuit Faults

For instance, an open circuit fault of an inverter switch of a channel if not managed can cause the voltage at the DC bus to increase above the DC bus overvoltage threshold when the back emf induced in the motor windings exceeds the voltage at the DC bus power under healthy operation (i.e. a supply voltage of a power supply providing power to the DC bus). This can occur when the speed of rotation of the rotor exceeds a certain speed.

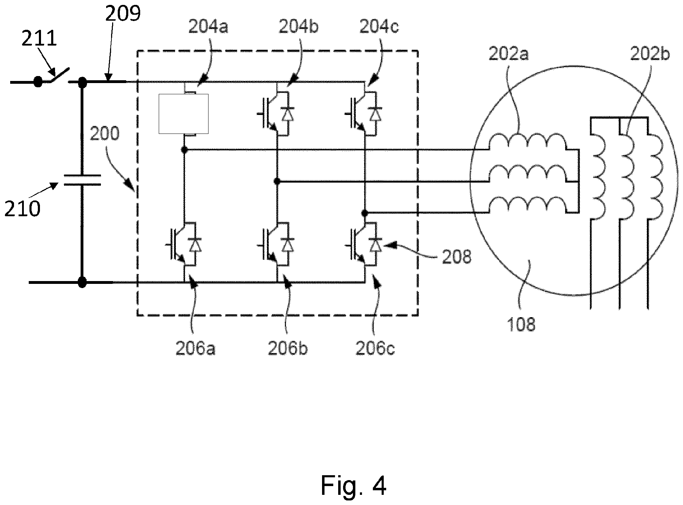

Figure 4 shows the inverter circuit 200 under a one switch open circuit fault. In Figure 4 switch 204a and its corresponding free-wheeling diode have an open circuit fault and are stuck in an open circuit, causing a fault in the motor channel associated with inverter circuit 200. It will be understood that any one of the switches of inverter circuit 200 can experience an open circuit fault, and the connections between the components of inverter circuit 200 can also experience open circuit faults.

It would be understood that any one of the switches and their corresponding free-wheeling diodes can undergo an open circuit fault, and be addressed in the manner described below.

Under such open circuit fault, therefore, the faulty channel can and should be controlled accordingly to maintain the voltage at the DC bus below the DC bus overvoltage threshold. In embodiments, the faulty channel is controlled to maintain the voltage at the DC bus below the DC bus overvoltage threshold when the motor speed exceeds a certain motor speed, such a motor speed being one at which the motor back emf would be higher than the DC bus voltage in healthy operation.

One way of managing the one switch open circuit fault is to switch off (open circuit) all switches of inverter 200 (i.e. configure the inverter 200 to be in a "regenerative", rectifier, configuration). In that case, the inverter 200 switches 204b,c and 206a,b,c (Figure 4) are switched off after the detection of the one switch open circuit fault affecting switch 204a.

At high motor speeds where the induced back emf is higher than the DC bus voltage, uncontrolled regenerative power will flow from the motor side to the DC bus causing high drag torque and high torque ripples. Drag torque may be high, and so the motor speed may have to be reduced if the healthy channel cannot overcome the drag torque produced by the faulty channel. However, so long as the DC bus 209 is still connected to its respective power supply, the DC bus voltage will remain below the DC bus overvoltage threshold as the DC bus voltage can be (and will be) regulated by the power supply's voltage regulator.

In this respect, where a power supply to the DC bus is connected to the DC bus and functioning, the voltage of the DC bus can be regulated below the DC bus overvoltage threshold by the power supply.

For instance, in embodiments where the back emf is greater than the DC bus voltage, regenerative power can be supplied to the DC bus from the continued rotation of the motor. However, in these embodiments, given the power supply to the DC bus is still connected and functioning, the power supply can vary its power being supplied to the DC bus to maintain the voltage at the DC bus below the DC bus overvoltage threshold.

Otherwise, where the regenerative power being delivered to the DC bus is lower than the power being supplied to the DC bus, no action may need to be taken as the power being supplied to the DC bus regulates the voltage at the DC bus to be maintained below the DC bus overvoltage threshold.

In this regard, the voltage of the DC bus can be monitored when the power inverter is in a regenerative configuration, and the power supply can be controlled to vary the power it is supplying to the DC bus based on the monitored DC bus voltage to maintain the DC bus voltage below the DC bus overvoltage threshold.

In this case, therefore, if there is also a fault in the channel such that there is a loss of power to the respective DC bus for that channel, the DC bus voltage should be maintained below the DC bus overvoltage threshold in other ways (described below).

As another example, rather than switching off inverter 200 switches of the faulty channel in the manner described above, a three-phase short circuit is applied to the motor terminals of the faulty channel, i.e. the motor phase windings of the channel with the fault are short circuited. This may be achieved by switching on either the upper or lower switches of inverter 200.

For instance, in the case of Figure 4, switches 206a, 206b and 206c can be short circuited. By doing so, the regenerative power to the DC bus is zero and the DC bus voltage is maintained at the voltage of the DC power supply providing power to the DC bus. This will then stop the back emf propagating to the DC bus 209 and hence maintain the voltage in the DC bus 209 below the DC bus overvoltage threshold. This action will reduce the motor drag torque and will eliminate the torque ripples in comparison to switching off all inverter 200 switches.

As yet another example, rather than short circuiting the motor phases of the faulty channel in the manner described above, the voltage on DC bus 209 may be controlled and maintained below the DC bus overvoltage threshold under an open circuit switch fault by applying field weakening control schemes to regulate the DC bus 209 voltage via the inverter circuit 200 to a level below the DC overvoltage threshold.

In this case, the field weakening control schemes may in embodiments be applied (only) for a motor speed above the certain motor speed (described above) (such a certain motor speed being one at which the motor back emf would be higher than the DC bus voltage in healthy operation, and therefore continued operation with the open circuit fault in the switch at or above this speed could potentially cause the voltage in the respective DC bus for the channel with the fault to increase above a DC bus overvoltage threshold for that channel).

Further, at higher motor speed, i.e. speeds greater than the certain speed, it may be desirable to apply control schemes other than field-weakening. For instance, at such higher motor speeds, there is the possibility of the conduction of motor current through the freewheeling diode of switch 206a in Figure 4 and the possibility of overvoltage to switch 206a which can limit the speed range for applying the field weakening.

As such, at higher motor speeds, other control schemes (e.g. entering a regenerative configuration or short circuiting the motor phases can be applied to avoid those effects.

Accordingly, when applying field weakening control to maintain the voltage of the DC bus below the DC bus overvoltage threshold for the channel with a (one) switch open circuit fault, the field weakening control is (only) applied for a certain range of motor speeds (and other control may therefore be performed if there is also a risk of DC bus overvoltage outside of that certain range of motor speeds).

Thus, there may be a first threshold motor speed at which it is determined that the DC bus voltage may exceed the DC bus overvoltage threshold, due to the continued rotation of the motor causing back emf, (e.g. the certain motor speed where the back emf induced in the motor windings exceeds the voltage at the DC bus power under healthy operation) and field weakening control schemes may be applied at motor speeds above this first threshold motor speed (the certain motor speed). There may also be a second threshold motor speed, higher the first threshold motor speed, at which it is desirable to apply control schemes other than field-weakening, such as applying a three-phase short circuit to the motor phase windings of the channel with the fault.

Accordingly, below the first threshold speed, any or no control schemes may be applied (as there is no risk of the DC bus voltage exceeding the DC bus overvoltage threshold because the voltage of the induced back emf is less than the DC bus voltage); between the first threshold and the second threshold, field-weakening control schemes may be applied; and at motor speeds exceeding the second threshold, control schemes other than field-weakening may be applied (e.g. the short circuiting of the motor phase windings).

Field weakening control schemes may desirable to mitigate/reduce drag torque for a speed range above a certain, threshold, motor speed (as discussed above) but at the expense of increased torque ripples (in comparison to applying a the three-phase short circuit as described above) when a channel experiences a one inverter switch open circuit fault.

Field weakening control being applied to the channel with the open circuit switch fault can be done for a motor speed range above a certain, threshold, motor speed with or without power being provided to the DC bus from its respective power supply.

For instance, DC bus 209 can be disconnected from a power supply that provides power to the DC bus (e.g. via a switch 211 along the DC bus), or the DC bus can remain connected to its power supply, and then field weakening control can be applied to the motor phases connected to the channel with the one switch open circuit fault when the motor speed exceeds the first threshold speed.

However, given there is an open circuit switch fault in the inverter circuit 200, only motor phases that are not directly affected by the open circuit switch fault (e.g. the motor phases that are not either the phase connected to the branch of inverter circuit 200 with the open circuit fault, i.e. controllable motor phases) can be effectively controlled using field weakening control. For example, in the case of Figure 4, field weakening control can be applied to the motor by controlling the switching of switches 204b, 206b, 204c, and 206c.

Therefore, to maintain the DC bus voltage below the DC bus overvoltage threshold when there is an open circuit (switch) fault in a channel, the DC bus of the inverter of the channel can be disconnected from the (DC) power source that provides power to it, and field weakening control can be applied to the motor phases of the channel other than that affected by the open circuit fault (i.e. the controllable motor phase (windings)) when the motor speed in above the first threshold speed (and optionally, below the second threshold motor speed).

Whilst applying such field weakening control to the channel with the open switch circuit fault can reduce the drag torque (but at the expense of increased torque ripples produced by the faulty channel in comparison to applying a three phase short circuit), it may be desirable to eliminate the drag torques entirely and use the faulty channel to provide assistive torque to assist in driving the rotation of the motor with another channel of the motor system.

Such assistive torque can be provided by applying field weakening control to the motor channel with the open circuit switch fault without disconnecting the DC bus of the inverter of the channel with the open circuit switch fault from its (DC) power supply (with the DC bus connected to its respective power supply).

### Example 3 - (One) Motor Phase Winding Open Circuit Faults

An open circuit fault in a (single) motor phase winding of a channel if not managed can also cause the voltage at the DC bus to increase above the DC bus overvoltage threshold when the back emf induced in the motor windings exceeds the voltage at the DC bus power under healthy operation (i.e. a supply voltage of a power supply providing power to the DC bus). This can occur when the speed of rotation of the rotor exceeds a certain ((first) threshold) speed (which can be the same as that described above).

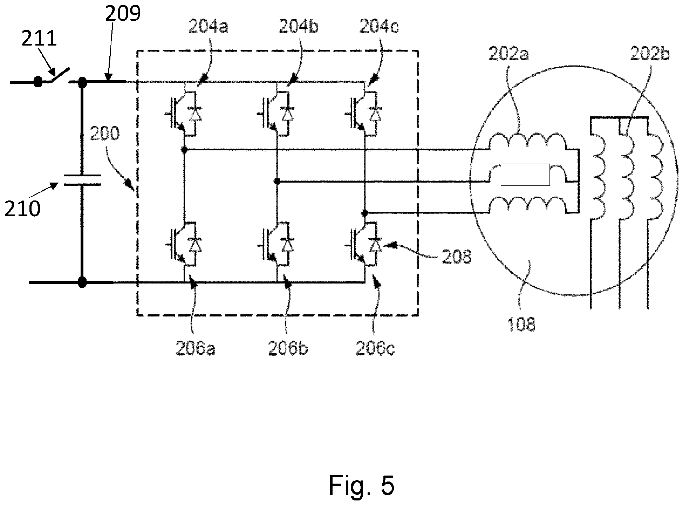

Figure 5 shows the inverter circuit 200 under a one motor phase (winding) open circuit fault. In Figure 5, a motor phase winding connected to the inverter circuit 200 experiences an open circuit fault. It would be understood that any of the motor phase windings can experience an open circuit fault.

Under an open circuit winding fault, therefore, the faulty channel can and should be controlled accordingly to maintain the voltage at the DC bus below the DC bus overvoltage threshold.

One way to prevent regenerative power to DC bus and to maintain the DC bus voltage below the DC bus overvoltage threshold under an open circuit fault is to short circuit the controllable motor phases of the faulty channel (i.e. the motor phases other than those which have an open circuit and hence which are still "controllable").

For instance, in the case of Figure 5, switches 204a and 204c (or 206a and 206c) are short circuited. By doing so, the regenerative power to the DC bus is zero and the DC bus voltage is maintained at the voltage of the supply providing power to the DC bus. In this respect, the voltage at the DC bus can be maintained below the DC bus overvoltage threshold, but there will be torque ripples produced as a result of the open circuit fault in a motor phase winding.

As another example, rather than short circuiting the controllable motor phases of the faulty channel in the manner described above, the voltage on DC bus 209 may be maintained below the DC bus overvoltage threshold under an open circuit winding fault by placing the inverter circuit 200 into a regenerative (rectifier) configuration, wherein the induced back emf in the channel with the fault will be rectified by the free-wheeling diodes of the inverter and regenerate power to the (power supply of the) DC bus.

For instance, considering inverter circuit 200, inverter circuit 200 can be placed into a regenerative (rectifier) configuration by controlling the switches of the upper and lower branches to be in an open circuit configuration (i.e. by switching off inverter 200). In such a configuration, inverter circuit 200 will then be controlled to rectify the induced back emf via the free-wheeling diodes 208, regenerating power to the (power supply of the) DC bus.

In the case of an open circuit fault in a motor phase winding connected to the inverter circuit 200, e.g. the situation depicted in Figure 5, the inverter circuit 200 can be placed into a regenerative, rectifier, configuration by suitably controlling all of the switches of the inverter circuit 200 to be in an open circuit configuration, or at least those switches that are associated with the controllable motor phases.

Other arrangements would be possible in this regard.

Placing the inverter with an open circuit fault into a regenerative (rectifier) configuration is a relatively simple way to maintain the DC bus voltage below the DC bus overvoltage threshold. However, the faulty channel, having the inverter with the open circuit fault, will produce higher drag torques and higher torque ripples as a result of acting as a generating channel.

In such a regenerative configuration, at high motor speeds where the induced back emf is higher than the DC bus voltage, uncontrolled regenerative power will flow from the motor side to the DC bus causing high drag torque and high torque ripples. Drag torque may be high, and so the motor speed may have to be reduced if the healthy channel cannot overcome the drag torque produced by the faulty channel. However, the DC bus voltage will remain below the DC bus overvoltage threshold due to the DC power supply voltage regulator, in a corresponding manner to that discussed with regard to the open circuit switch fault.

In this case, therefore, if there is also a fault in the channel such that there is a loss of power to the respective DC bus for that channel, the DC bus voltage should be maintained below the DC bus overvoltage threshold in other ways (i.e. by shorting the healthy motor phases, or by applying field weakening control, as discussed below).

Field weakening control schemes may therefore be desirable to mitigate/reduce against drag torques and/or torque ripples when a channel experiences a one motor phase open circuit fault. By using field weakening control schemes, the voltage at the DC bus can be controlled to a level below the DC overvoltage threshold.

Field weakening control being applied to the channel with the open circuit (phase winding) fault can be done with or without power being provided to the DC bus from its respective power supply.

For instance, DC bus 209 can be disconnected from a power supply that provides power to the DC bus (e.g. via a switch 211 along the DC bus), or the DC bus can remain connected to its power supply, and then field weakening control can be applied to the motor phases connected to the channel with the open circuit fault.

However, given there is an open circuit fault in a motor phase winding, only motor phases that are not directly affected by the open circuit fault (e.g. the motor phases of the motor phase windings other than that with the open circuit fault, i.e. controllable motor phases) can be effectively controlled using field weakening control. For example, in the case of Figure 5, field weakening control can be applied by controlling the switching of switches 204a, 206a, 204c, and 206c.

Therefore, to maintain the DC bus voltage below the DC bus overvoltage threshold when there is an open circuit fault in a channel (and when the rotational speed of the rotor is above a certain rotational speed), the DC bus of the inverter of the channel can be disconnected from the (DC) power source that provides power to it, and field weakening control can be applied to the motor phases of the channel other than that affected by the open circuit fault (i.e. the controllable motor phase (windings)).

Whilst applying such field weakening control to the channel with the open circuit fault can reduce the drag torques and torque ripples produced by the faulty channel, it may be desirable to eliminate the drag torques entirely and use the faulty channel to provide assistive torque to assist in driving the rotation of the motor with another channel of the motor system.

Such assistive torque can be provided by applying field weakening control to the motor channel with the open circuit phase winding fault without disconnecting the DC bus of the inverter of the channel with the open circuit fault from its (DC) power supply (i.e. by applying field weakening control with the DC bus connected to its respective power supply).

Compared to the open circuit fault in a switch of a channel, when there is an open circuit fault in a motor phase winding of a channel, field weakening control can be applied at any motor speed (up to e.g. the maximum motor speed), and in an embodiment are applied above the certain speed at which the induced back emf has a greater voltage than that of the DC bus (i.e. there is no upper threshold at which other control schemes should be applied, however other control schemes can be applied at any such upper threshold, if desired).

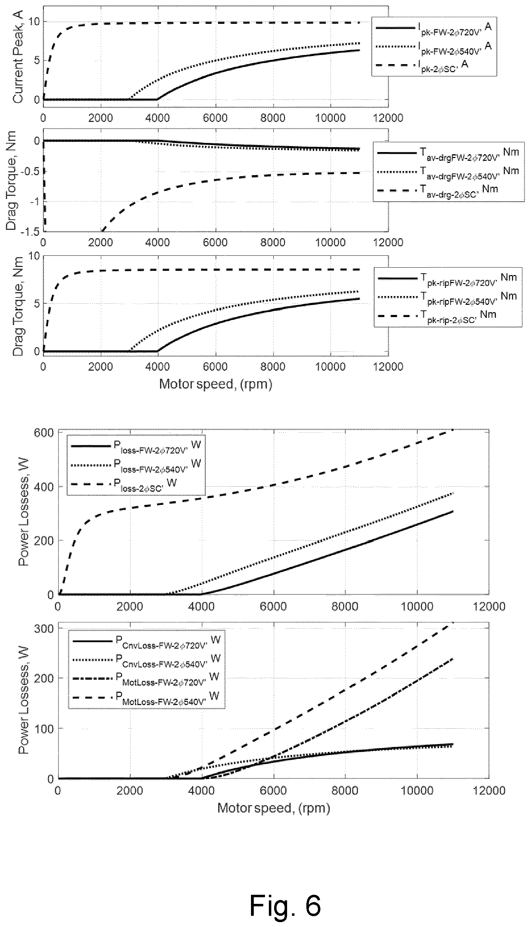

Figure 6 shows simulation results of applying a short circuit to the controllable motor phases and applying field weakening control to the controllable motor phases with the DC bus disconnected from its respective power source, under a one motor phase (winding) open circuit fault of the motor channel. In particular, Figure 6 shows peak currents, average drag torques, peak torque ripples and power losses, in the faulty channel when applying field weakening control (controlling the DC bus voltage to either 540VDC or 720VDC), and when applying a short circuit to the controllable motor phases of the faulty channel.

As can be seen from Figure 6, by disconnecting the DC bus from its (DC) power supply and applying field weakening control to the controllable motor phases of the channel with the one motor phase winding open circuit fault, reduced average drag torques and torque ripples and power losses can be achieved.

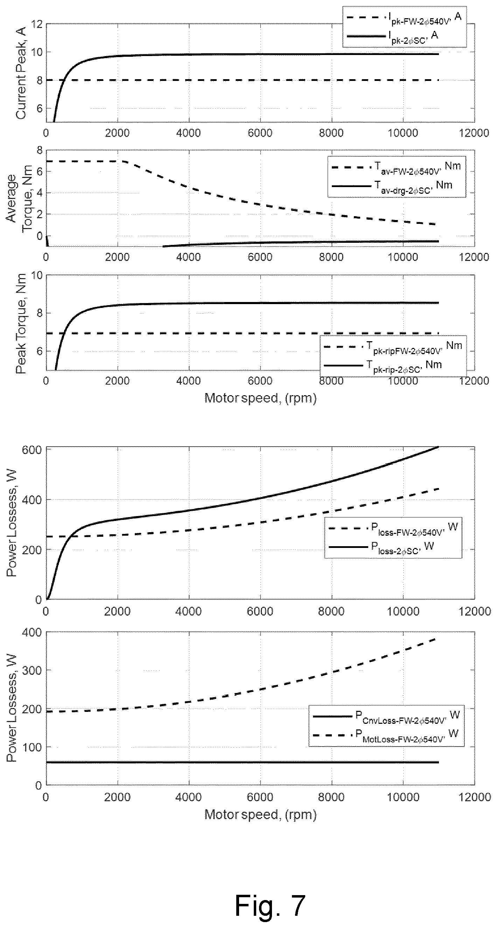

Figure 7 is similar to Figure 6 but shows the results of applying a short circuit to the controllable motor phases and applying field weakening control to the controllable motor phases with the DC bus still connected to its respective power source, under a one motor phase winding open circuit fault of the motor channel.

As can be seen from Figure 7, by applying field weakening control to the channel with the one motor phase open circuit fault in this manner, reduced power losses and assistive torque can be achieved.

### Other Faults

There may also be other types of faults that occur that do not risk the DC bus voltage exceeding the DC bus overvoltage threshold, and so these do not need to be handled in the same way. In that case, other control schemes may be applied, or the fault could be ignored, if it is safe to do so.

For instance, another fault that might occur would be a one-switch short circuit. This would not typically impact the DC bus voltage and so the particular control according to the technology described herein may not be applied. This may however increase drag torque and so other control schemes may be applied to reduce the drag torque, such as the solution presented in United States Patent No. 10,320,183 (assigned to Goodrich Actuation Systems Limited), the entire contents of which are incorporated herein by reference.

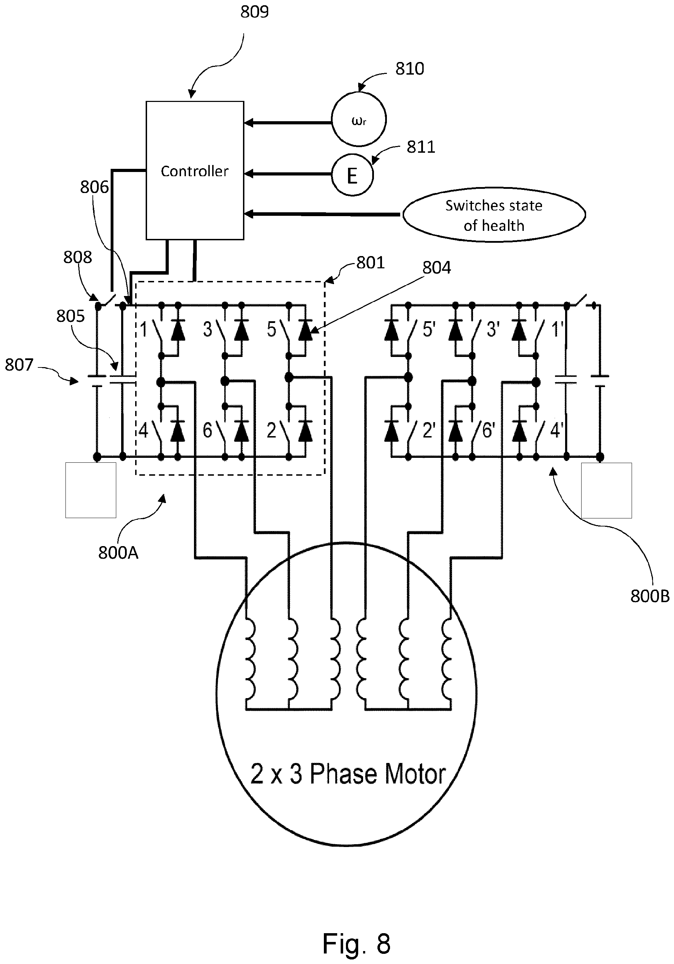

Another possible fault would be loss of power to the system control board, such that the switching control is lost. In that case, the DC link capacitor 210 should remain connected to its power supply via DC bus switch 211 (Figure 5), but no further action is required since the DC bus voltage will be natural regulated. For example, the DC link capacitor 210 may be kept connected to the DC power supply 807 (Figure 8) using appropriate monitoring and protection hardware circuitry/logic and this will remain operational in this event. Again, in this case, drag torque may be increased, and so the motor speed may have to reduce if the healthy channel cannot overcome the drag torque. However, the DC bus voltage will remain below the DC bus overvoltage threshold.

### Controller

Figure 8 shows an embodiment of a multi-channel motor drive system operable to implement the particular control operations described above. In particular, Figure 8 shows a dual channel three-phase motor system, wherein each channel 800A, 800B, comprises a three-phase inverter 801 with upper branch switches 1, 3, and 5, lower branch switches 4, 6, and 2, and free-wheeling diodes 804 connected in parallel to each switch 1 to 6.

Figure 8 further shows a DC bus capacitor 805 connected across the terminals of the DC bus 806 of the inverter/motor channel, and a DC power supply 807 connected to the DC bus each respective the motor channel. Figure 8 also shows a switch 808 connected between the DC power supply and the DC bus of each respective motor channel, switch 808 operable to isolate the inverter, and the DC bus capacitor 805, of each motor channel from its respective DC power supply.

Figure 8 also shows controller 809 connected to channel 800A. Controller 809 is configured to control channel 800A to maintain the voltage at the DC bus 806 of channel 800A below the DC bus overvoltage threshold when it is detected that there is a fault in channel 800A and when the induced back emf in the motor phase windings of channel 800A can cause the voltage at the DC bus to exceed the DC bus overvoltage threshold.

Controller 809 can monitor the rotational speed 810 of the rotor of the motor, and/or back emf 811 induced in the motor phase windings of channel 800A due to the rotation of the rotor. Controller 809 can also monitor the voltage of the DC bus 806 and the state of health of the inverter switches of channel 800A (i.e. whether the switches, and their corresponding free-wheeling diodes, have experienced a short or open circuit fault). Controller 809 can also monitor whether any one of the motor phase windings have experienced an open circuit fault.

The controller 809 may thus include one or more fault detection circuits that are operable and configured to determine any of the faults described above (and the controller 809 can then select an appropriate control to perform for that particular type of fault). This can be done in any suitable manner, as desired. For example, this may be done using dedicated fault detection circuits associated with the respective components discussed above, or may be done in part based on the monitoring of the voltage on the DC bus, for example.

As controller 809 can also monitor the rotational speed of the rotor of the motor, and/or the back emf induced in the motor phase windings of channel 800A, controller 809 can also determine whether the back emf induced in the motor phase windings of channel 800A could potentially cause the DC bus voltage to exceed the DC bus overvoltage threshold under the identified fault.

For instance, controller 809 can determine whether the rotational speed of the motor exceeds a certain (predetermined) threshold speed, and/or whether the monitored back emf exceeds a certain value, to therefore determine whether the back emf induced in the motor phase windings of channel 800A will cause the DC bus voltage to exceed the DC bus overvoltage threshold under the identified fault.

Accordingly, when controller 809 determines that channel 800A has a fault, and that the back emf induced in the motor phase windings of channel 800A could potentially cause the DC bus voltage to exceed the DC bus overvoltage threshold (e.g. based on whether the monitored rotational speed of the rotor of the motor exceeds a certain speed, and/or based on whether the monitored back emf exceeds a certain value) (e.g. when it is determined that the motor speed exceeds a certain (first threshold) speed where the motor back emf in channel 800A would be higher than the DC bus voltage in healthy operation), the controller can then perform an appropriate control operation for the channel 800A having the fault based on the type of fault to maintain the voltage at the DC bus 806 below the DC overvoltage threshold (and in some cases to reduce the motor drag torque).

As described above, there are several ways the controller 809 can control channel 800A when there is a fault in channel 800A.

For instance, if there is a loss of power to the DC bus 806 of channel 800A, the controller can be configured to apply a three-phase short circuit to the motor phases of channel 800A by either causing the upper branch switches or lower branch switches of inverter 801 of channel 800A to short circuit, as appropriate.

Alternatively, controller 800A can apply field weakening control to channel 800A, by directly controlling the switching of the switches of the inverter, or by controlling a switch driver controller (not illustrated) to control the switches of the inverter to apply field weakening control, and control the voltage at the DC bus 806 below the DC overvoltage threshold.

Furthermore, if channel 800A has an open circuit fault (an open circuit fault in a switch of inverter 801, or in a motor phase winding) then controller 800A can control channel 800A to maintain the DC bus voltage below the DC bus overvoltage threshold by controlling invertor 801 of channel 800A to enter into a regenerative (rectifier) configuration (so long as the respective power supply for the DC bus is connected to the DC bus and functioning) whereby the induced back emf will be rectified and regenerate to the DC bus (i.e. to cause the switches of inverter 801 to be in an open circuit configuration).

In embodiments, to configure the inverter 801 to enter into a regenerative configuration, as described above, it is first determined whether the respective power supply 807 for the channel 800A is still connected and functioning, when it is determined that the power supply 808 is still connected and functioning, the inverter 801 is configured to enter into a regenerative configuration. Otherwise, the motor phases can be short-circuited (rather than configuring the inverter to enter into a regenerative configuration, or when it is determined that the power supply is neither connected nor functioning, or as an alternative to entering into a regenerative configuration.)

Alternatively, under an open circuit fault of channel 800A, controller 809 can apply a short circuit to the controllable motor phases of the motor phase windings of channel 800A (which in the case of an open circuit fault in a switch are all of the motor phases (and in this case the short circuit can be applied by short circuiting either the upper branch or lower branch switches of inverter 801, as appropriate), and which in the case of an open circuit fault in a motor phase winding are the motor phase windings other than those with the open circuit fault).

Alternatively, under open circuit faults of channel 800A, controller 809 can apply field weakening control to channel 800A to maintain the DC bus voltage below the DC overvoltage threshold.

In the case of open circuit faults in a (single) switch of channel 800A, the controller monitors the rotational speed of the motor, and applies field weakening control schemes when the motor speed is above a certain (i.e. a first threshold) speed (such a speed being one at which the motor back emf in channel 800A would be higher than the DC bus voltage in healthy operation).

Under an open circuit fault in a (single) switch of channel 800A, when the rotational speed of the motor is higher than a second threshold, speed (the second threshold scheme being greater than the certain (first threshold) speed), the controller can apply any other appropriate control scheme to maintain the DC bus voltage below the DC bus overvoltage threshold.

For instance, if the speed of the motor is above the certain (first threshold) speed, but below the second threshold speed, the controller applies field-weakening control to maintain the DC bus voltage below the DC bus overvoltage threshold. Otherwise, if the speed of the motor exceeds the second threshold speed, the controller can apply a three-phase short circuit to the motor phases of channel 800A, or control invertor 801 of channel 800A to enter into a regenerative configuration.

If the speed of the motor is below the certain (first threshold) speed, the voltage of the back emf does not exceed the voltage of the DC bus, and so no control actions may be performed by the controller as continued operation with the open circuit fault in the switch would not potentially cause the voltage in the respective DC bus for the channel with the fault to increase above a DC bus overvoltage threshold for that channel. However, in embodiments, the controller applies any of the herein described control schemes.

In the case of an open circuit fault in a motor phase winding of channel 800A, controller 800A can apply field weakening control schemes at any rotational speed of the motor (up to e.g. the maximum motor speed), but in an embodiment this is done when the speed of the motor is above the certain (first threshold) speed.

Further, in the case of applying field weakening control to channel 800A, for either open circuit faults in a switch of channel 800A or in a motor phase winding of channel 800A, controller 809 can also be configured to disconnect the DC bus 806 from its power supply by controlling switch 808 to be in an open circuit, and then applying field weakening control to the controllable motor phases of channel 800A.

In any case, controller 809 may be operable to control switches of channel 800A directly, or via other switch driver controller(s)/circuit(s), as appropriate.

It will be appreciated that the controller can determine which kind of fault there is in a channel, and can apply any one of the above described control schemes accordingly.

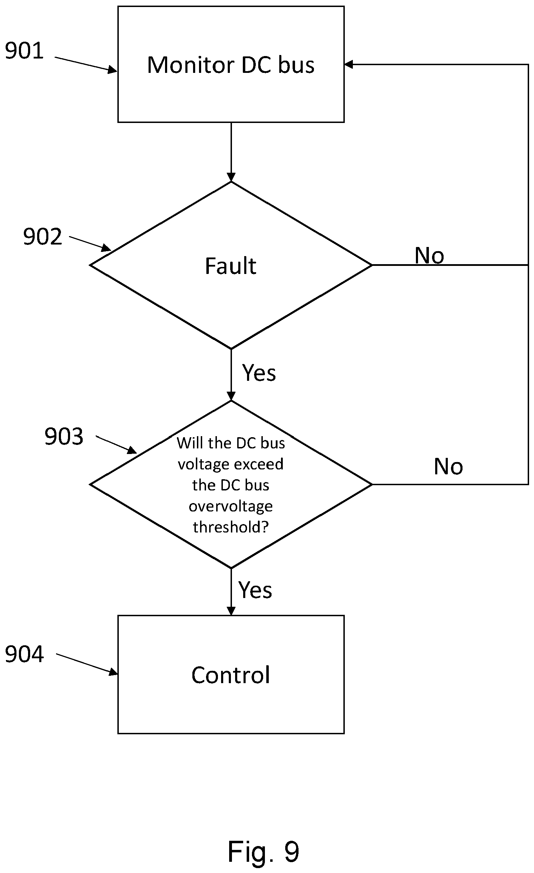

Figure 9 is a flowchart for maintaining the voltage at a DC bus of a motor channel of a multi-channel motor drive system under its DC bus overvoltage threshold when that channel experiences a fault.

The method shown in Figure 9 can, for example, be implemented by controller 809 of Figure 8.

Figure 9 begins with monitoring the voltage at a DC bus of a channel of a multi-channel motor drive system. The rotational speed of the motor and/or the back emf induced in the motor phase windings of the channel can also be monitored (step 901).

Following this, it is then determined whether there is a fault in the motor channel (step 902). For instance, based on the monitoring of the DC bus voltage of the channel, it can be determined whether there is a fault in the motor channel as the DC bus voltage can change by a certain (predetermined, threshold) amount. Additionally, or alternatively, an external indication can be provided that indicates that there is a fault in the motor channel.

If it is determined that there is not a fault in the motor channel (step 902 - No), then the voltage on the DC bus will continue to be monitored (step 901).

If it is determined that there is a fault in the motor channel (step 902 - Yes), it is then determined whether the DC bus voltage will increase above the DC bus overvoltage threshold (step 903). For instance, this can be done by determining whether the monitored rotational speed of the rotor is above a certain value (e.g. at a certain value where the voltage level of the back emf will exceed the DC bus voltage) (thereby causing the back emf to increase above a certain level causing the DC voltage at the DC bus to increase above the DC overvoltage threshold), and/or by directly determining that the voltage on the DC bus has increased above a certain level.

If it is determined that the DC bus voltage will not increase, or has not increased, above the DC bus overvoltage threshold (step 903 - No) under the current operation conditions, then no corrective action is taken, but the voltage at the DC bus will continue to be monitored (step 901.)

If it is determined that the DC bus voltage will increase, or has increased, above the DC bus overvoltage threshold (step 903 - Yes), the motor channel is then controlled appropriately to maintain the DC bus voltage below the DC bus overvoltage threshold (step 904). As discussed above, the manner in which the motor channel is controlled to maintain the DC bus voltage below the DC bus overvoltage threshold depends on the configuration of the system, and the type of fault.

As such, step 904 can comprise determining the type of fault in the motor channel (i.e. whether there is a loss of power to the DC bus from its power supply, or whether there is an open circuit fault in the motor channel (e.g. either a (single) open circuit fault in a switch of the motor channel, or a (single) open circuit fault in a motor phase winding of channel 800A)), and controlling the motor channel according to the fault.

The technology described herein therefore provides an effective way to maintain the voltage at the DC bus of a motor channel of a multi-channel drive system below its DC bus overvoltage threshold when there is a fault in that motor channel under a condition that the DC bus voltage can exceed the DC bus overvoltage threshold (due to the induced back emf in that motor channel).

While the above examples have been provided primarily with reference to example three-phase inverter topologies, embodiments of the invention extends to other configurations of inverter topologies, including but not limited to single-phase topologies (such as 1, 2, 3, 4, etc.-phase topologies) and multiple three-phase topologies (such as 3, 6, 9, etc.-phase topologies). In each case, it will be understood that the number of components such as switches and freewheeling diodes may be varied accordingly.

It will be further understood that while the above embodiments of the present invention have been described with reference to a single level inverter that provides power directly to the windings of a motor, the inverter may instead be incorporated into a multi-level system and instead be configured to receive and/or provide AC output current to another or other inverter(s).

Additionally, while the above examples have been provided primarily with reference to example dual channel systems, embodiments of the invention further extend to permanent magnet motor drive systems with different numbers of inverters and/or channels, including but not limited to triple channel, etc., motor drive systems.

Variations on the examples described above fall within the scope of the claims.

## Claims

1. A method of operating a fault tolerant electric motor system, wherein the motor system comprises a motor that comprises a rotor having a magnet mounted thereto and a stator that comprises one or more motor phase windings connected to a motor drive system for driving rotation of the rotor, wherein the motor drive system comprises a plurality of channels, each channel of the plurality of channels comprising a respective power inverter that can be controlled to provide torque to a respective one of the motor phase windings for driving rotation of the rotor and a respective DC bus for providing power to the respective power inverter, the method comprising:
determining that there is a particular fault in one of the channels of the motor drive system; and
continuing operating the motor system by driving rotation of the rotor using at least one other channel of the motor drive system,
wherein when the particular fault is one that as a result of the continued rotation of the rotor could potentially cause the voltage in the respective DC bus for the channel with the fault to increase above a DC bus overvoltage threshold for that channel, the method further comprises:
controlling the operation of the channel with the fault to maintain the voltage in its respective DC bus below the DC bus overvoltage threshold for that channel.

2. The method of claim 1, further comprising: monitoring, during the continued operating of the motor system, the voltage in the respective DC bus of the channel with the fault and/or the motor speed, and wherein the controlling the operation of the channel with the fault to maintain the voltage in its respective DC bus below the DC bus overvoltage threshold for that channel is performed based on the monitoring of the voltage in the respective DC bus of the channel with the fault and/or the motor speed.

3. The method of claim 1 or 2, wherein the particular fault in the one of the channels of the plurality of channels is a loss of power to the respective DC bus for that channel, and wherein the method comprises:
controlling the operation of the channel with the fault to maintain the voltage in the DC bus for the channel with the fault below the DC bus overvoltage threshold for that channel by applying field weakening control to the channel with the fault.

4. The method of claim 1, 2 or 3, wherein each channel provides a plurality of motor phases, and wherein the particular fault in the one of the channels of the plurality of channels is an open circuit fault affecting one of the motor phases in the channel with the fault such that the affected motor phase is no longer controllable, but wherein the other motor phases are still controllable, and wherein the method comprises:
controlling the operation of the channel with the fault to maintain the voltage in the DC bus for the channel with the fault below the DC bus overvoltage threshold for that channel by applying field weakening control to the channel with the fault, the field weakening control being applied using the other, controllable motor phases of that channel.

5. The method of claim 4, comprising disconnecting a respective power supply from the DC bus of the channel with the fault and applying the field weakening control using the controllable motor phases of that channel whilst the respective power supply is disconnected.

6. The method of claim 4 or 5, wherein when the open circuit fault affecting one of the motor phases in the channel with the fault is an open circuit fault in one switch of the respective inverter of the channel with the fault:
the field weakening control using the controllable motor phases of that channel is applied when the motor speed is greater than or equal to a certain first threshold speed and less than or equal to a second threshold speed, the second threshold speed being greater than the first threshold speed, whereas when the motor speed is higher than the second threshold speed, other control is performed to maintain the voltage in the DC bus for the channel with the fault below the DC bus overvoltage threshold.

7. The method of claim 1 or 2, wherein the particular fault in the one of the channels of the plurality of channels is an open circuit fault affecting one of the motor phases in the channel, and wherein the method comprises:
so long as a respective power supply for the DC bus of the channel with the fault is connected and functioning:
configuring the respective power inverter of the channel with the fault to be in a regenerative configuration such that the power inverter generates power to the DC bus, the respective power supply for the DC bus maintaining the voltage in the DC bus for the channel with the fault below the DC bus overvoltage threshold for that channel.

8. A fault tolerant electric motor system, the electric motor system comprising a motor that comprises a rotor having a magnet mounted thereto and a stator that comprises one or more motor phase windings connected to a motor drive system for driving rotation of the rotor, wherein the motor drive system comprises a plurality of channels, each channel of the plurality of channels comprising a respective power inverter that can be controlled to provide torque to a respective one of the motor phase windings for driving rotation of the rotor and a respective DC bus for providing power to the respective power inverter, a control circuit of the motor drive system is configured to:
determine that there is a particular fault in one of the channels of the motor drive system; and
continue to operate the motor system by driving rotation of the rotor using at least one other channel of the motor drive system,
wherein when the particular fault is one that as a result of the continued rotation of the rotor could potentially cause the voltage in the respective DC bus for the channel with the fault to increase above a DC bus overvoltage threshold for that channel, control the operation of the channel with the fault to maintain the voltage in its respective DC bus below the DC bus overvoltage threshold for that channel.

9. The electric motor system of claim 8, wherein the control circuit of the motor drive system is further configured to:
monitor, during the continued operating of the motor system, the voltage in the respective DC bus of the channel with the fault and/or the motor speed, and control the operation of the channel with the fault to maintain the voltage in its respective DC bus below the DC bus overvoltage threshold for that based on the monitoring of the voltage in the respective DC bus of the channel with the fault and/or the motor speed.

10. The electric motor system of claim 8 or 9, wherein the particular fault in the one of the channels of the plurality of channels is a loss of power to the respective DC bus for that channel, and wherein the control circuit of the motor drive system is configured to:
control the operation of the channel with the fault to maintain the voltage in the DC bus for the channel with the fault below the DC bus overvoltage threshold for that channel by applying field weakening control to the channel with the fault.

11. The electric motor system of any one of claims 8 to 10, wherein each channel provides a plurality of motor phases, and wherein the particular fault in the one of the channels of the plurality of channels is an open circuit fault affecting one of the motor phases in the channel with the fault such that the affected motor phase is no longer controllable, but wherein the other motor phases are still controllable, and wherein the control circuit of the motor drive system is configured to:
control the operation of the channel with the fault to maintain the voltage in the DC bus for the channel with the fault below the DC bus overvoltage threshold for that channel by applying field weakening control to the channel with the fault, the field weakening control being applied using the other, controllable motor phases of that channel.

12. The electric motor system of claim 11, wherein the control circuit of the motor drive system is configured to disconnect a respective power supply from the DC bus of the channel with the fault and apply field weakening control using the controllable motor phases of that channel whilst the respective power supply is disconnected.

13. The electric motor system of claim 11 or 12, wherein when the open circuit fault affecting one of the motor phases in the channel with the fault is an open circuit fault in one switch of the respective inverter of the channel with the fault:
the field weakening control using the controllable motor phases of that channel is applied when the motor speed is greater than or equal to a certain threshold speed and less than or equal to a second threshold speed, the second threshold speed being greater than the certain threshold speed, whereas when the motor speed is higher than the second threshold speed, other control is performed to maintain the voltage in the DC bus for the channel with the fault below the DC bus overvoltage threshold..

14. The electric motor system of claim 8 or 9, wherein the particular fault in the one of the channels of the plurality of channels is an open circuit fault affecting one of the motor phases in the channel, and wherein the control circuit of the motor drive system is configured to:
so long as a respective power supply for the DC bus of the channel with the fault is connected and functioning:
configure the respective power inverter of the channel with the fault to be in a regenerative configuration such that the power inverter generates power to the DC bus, the respective power supply for the DC bus maintaining the voltage in the DC bus for the channel with the fault below the DC bus overvoltage threshold for that channel.

15. The method of claim 1 or 2, or the electric motor system of claim 8 or 9, wherein controlling the operation of the channel with the fault to maintain the voltage in its respective DC bus below the DC bus overvoltage threshold for that channel comprises applying a short circuit to motor phases of the channel with the fault.
